# EUROPÄISCHE PATENTSCHRIFT

(11) **EP 1 872 142 B1**
(45) Veröffentlichungstag und Bekanntmachung des Hinweises auf die Patenterteilung: **10.04.2013**
(21) Anmeldenummer: 06706862.7
(22) Anmeldetag: 10.02.2006
(51) Int. Cl.: G01R 27/04, G01R 35/00

(54) **KALIBRIERVORRICHTUNG UND KALIBRIERVERFAHREN ZUM ABGLEICH EINES RICHTKOPPLER-MESSSYSTEMS**
CALIBRATION DEVICE AND CALIBRATION METHOD FOR ADJUSTING A DIRECTIONAL COUPLER MEASURING SYSTEM
DISPOSITIF DE CALIBRAGE ET PROCEDE DE CALIBRAGE POUR REGLER UN SYSTEME DE MESURE A COULEUR DIRECTIONNEL

(30) Priorität: 19.04.2005 DE 102005018090
(43) Veröffentlichungstag der Anmeldung: 02.01.2008
(73) Patentinhaber: Rohde & Schwarz GmbH & Co. KG, 81671 München (DE)
(72) Erfinder: KAEHS, Bernhard, 82008 Unterhaching (DE)
(74) Vertreter: Körfer, Thomas
(86) Internationale Anmeldenummer: PCT/EP2006/001241
(87) Internationale Veröffentlichungsnummer: WO 2006/111213

(56) Entgegenhaltungen:
- EP-A- 0 479 168
- EP-A- 0 715 177
- WO-A-00/30272
- WO-A-99/21025
- WO-A-02/054092
- WO-A-2005/010537
- US-A- 4 290 009
- US-A- 5 471 146

## Beschreibung

Die vorliegende Erfindung betrifft eine Kalibriervorrichtung gemäß des Anspruchs 1 und ein Kalibrierverfahren gemäß des Anspruchs 11 zum Abgleich eines an eine Hochfrequenz-Sendeeinrichtung angeschlossenes Richtkoppler-Messsystem.

Aus der WO 02/054092 A1 ist eine Vorrichtung bekannt mit der sowohl die Spannung der vorwärtslaufenden Welle als auch die Spannung der rückwärtslaufenden Welle auf einer Hochfrequenz-Leitung mittels eines Richtkopplers gemessen und qualitativ ausgewertet werden, wobei beim Überschreiten eines vorher festgelegten Schwellwertes ein Alarm ausgelöst wird. Der Nachteil der in der oben genannten Druckschrift beschriebenen Vorrichtung besteht darin, dass keine korrigierte und abgeglichene Anzeige vorgesehen ist, die den Messwert der beiden Spannungen dem Benutzer der Vorrichtung mit einer hinreichenden Genauigkeit anzeigt. Außerdem erfolgt die Messung der verlaufenden Welle und der rücklaufenden Welle über getrennte Sensoren, wodurch die Genauigkeit der Vergleichsmessung wegen unterschiedlicher Toleranzen der beiden verwendeten Detektoren beeinträchtigt ist.

In der WO 00/30272 A wird eine Methode beschrieben, den dynamischen Bereich beim Messen des rückgekoppelten Verlustes auf einem Koaxialkabel mit einem Richtkoppler auszudehnen. Für Messung in Vorwärts- und Rückwärtsrichtung wird ein gemeinsamer Messzweig benutzt. Mittels eines Switches wird zeitliches Multiplexing durchgeführt.

Die WO 99/21025 A offenbart ein automatisches Testsystem für Mikrowellenkomponenten. Es beinhaltet eine intern zuschaltbare Referenz, die zur Kalibrierung dient. Teil der Kalibrierung ist es, die von einer Quelle einfallende Leistung zu messen. Während der Messung wird die Kalibrierreferenz umgeschaltet, um die Leistung zu verändern, die an die Quelle zurückreflektiert wird. Änderungen in der einfallenden Leistung werden kontinuierlich gemessen während die Änderungen auftreten. Aus den Messungen kann die Quellenanpassung bestimmt werden. Es wird eine Korrektur durchgeführt, so dass eine Anpassung bezüglich der Quelle durchgeführt wird.

In der EP 0 715 177 A2 wird ein Aufbau gezeigt, um S-Parameter und andere hochfrequente Kurven zu messen. Dies geschieht mit einem HF-Modul, welches einen Gleichrichter beinhaltet, welcher einem Receiver erlaubt, das Eingangs- und Ausgangssignal eines Messpunktes zu messen. Das Modul beinhaltet Kalibrierstandards für die Quelle und den Empfänger.

Die US 5,471,146 A offenbart ein Reflexionsverlustmessgerät für Basisstationen, das zwei Transmittern, zwei Receivern und zwei Antennen aufweist. Die beiden Transceiver sind durch einen Richtkoppler gekoppelt, welcher umgeschalten werden kann. Das Reflexionsverlustgerät beinhaltet zwei Geräte, um die reflektierte und einfallende Leistung der beiden Antennen zu messen unter Verwendung von jeweils einem schaltbaren Richtkoppler.

In der EP 0 479 168 A2 wird ein Gerät offenbart, welches eine Antenne überwacht. Dabei werden mehrere Trägersignale im Multiplexbetrieb aus einigen Transmittern durch eine Übertragungsstrecke in eine Antenne gespeist. Durch einen Richtkoppler werden Vorwärtssignale und Rückwärtssignale, die von der Antenne reflektiert wurden, getrennt. Durch Bandpassfilter werden die unterschiedlichen Signale getrennt und auf Detektoren gegeben. Daraus berechnet ein Mikroprozessor das Stehwellenverhältnis.

Die WO 2005/010537 A1 offenbart eine WLAN-Empfangseinheit, bei der nach der Antenne ein Verstärker offenbart wird. Ferner werden Maßnahmen diskutiert, den Empfang stabiler zu gestalten.

Der Erfindung liegt daher die Aufgabe zugrunde, eine Kalibriervorrichtung und ein Kalibrierverfahren zum Abgleich eines an eine Hochfrequenz-Sendeeinrichtung angeschlossenes Richtkoppler-Messsystems zu schaffen, wobei sowohl die Messung als auch die Kalibrierung und der Abgleich des Richtkoppler-Messsystems hinsichtlich einer korrigierten Anzeige des Messwertes der in die Hochfrequenz-Sendeeinrichtung reflektierten Rücklaufleistung mit nur einem Messrichtkoppler erfolgen soll.

Die Aufgabe wird bezüglich der Kalibriervorrichtung durch die Merkmale des Anspruchs 1 und bezüglich des Kalibrierverfahrens durch die Merkmale des Anspruchs 11 gelöst. Die Erfindung betrifft eine Kalibriervorrichtung, die einen Messsensor und eine daran angeschlossene Steuer- und Anzeigeeinheit zum Abgleich der an einer Hochfrequenz-Sendeeinrichtung über einen einzigen Messrichtkoppler gemessenen Vorlauf- und Rücklaufleistung umfasst. Dabei erfolgt vor der Messung der Abgleich bezüglich der mit einer hinreichenden Genauigkeit bekannten, auf einer Sendeleitung der Hochfrequenz-Sendeeinrichtung zu einer Antenne transportierten Vorlaufleistung, wobei der Referenzwert für den Abgleich die mit einer hinreichenden Genauigkeit bekannte emittierte Vorlaufleistung der Hochfrequenz-Sendeeinrichtung ist. Die erfindungsgemäße Kalibriervorrichtung weist einen Umschalter auf, der über eine Steuerleitung mit der Steuer- und Anzeigeeinheit verbunden ist, wobei ein von der Steuer- und Anzeigeeinheit den Umschalter betätigendes Steuersignal ausgesandt wird, wodurch von einer Messung der Rücklaufleistung auf eine Messung der Vorlaufleistung mittels des gleichen Messsensors zurückgeschaltet wird, wobei die Messung der Vorlaufleistung und die Messung der Rücklaufleistung über den selben Messrichtkoppler erfolgen.

Vorteilhafte Weiterbildungen der Erfindung sind in den Unteransprüchen angegeben.

Die Erfindung wird nachfolgend unter Bezugnahme auf die Zeichnung näher beschrieben. In der Zeichnung zeigen
- Fig. 1: ein Schaltbild eines Messsystems gemäß dem Stand der Technik zum Abgleich der gemessenen Vorlauf- und Rücklaufleistung und zur anschließenden wahlweisen Messung der Vorlauf- oder der Rücklaufleistung in einem Sendesystem;
- Fig. 2: ein vereinfachtes Schaltbild einer Kalibriervorrichtung zum Abgleich der an einer Hochfrequenz-Sendeeinrichtung mittels eines einzigen Messrichtkopplers gemessenen Vorlauf- und Rücklaufleistung;
- Fig. 3: ein detaillierteres Schaltbild eines ersten Schaltzustands einer erfindungsgemäßen Kalibriervorrichtung zum Abgleich der an einer Hochfrequenz-Sendeeinrichtung mittels eines einzigen Messrichtkopplers gemessenen Vorlauf- und Rücklaufleistung;
- Fig. 4: ein detaillierteres Schaltbild eines zweiten Schaltzustands einer erfindungsgemäßen Kalibriervorrichtung zum Abgleich der an einer Hochfrequenz-Sendeeinrichtung mittels eines einzigen Messrichtkopplers gemessenen Vorlauf- und Rücklaufleistung.

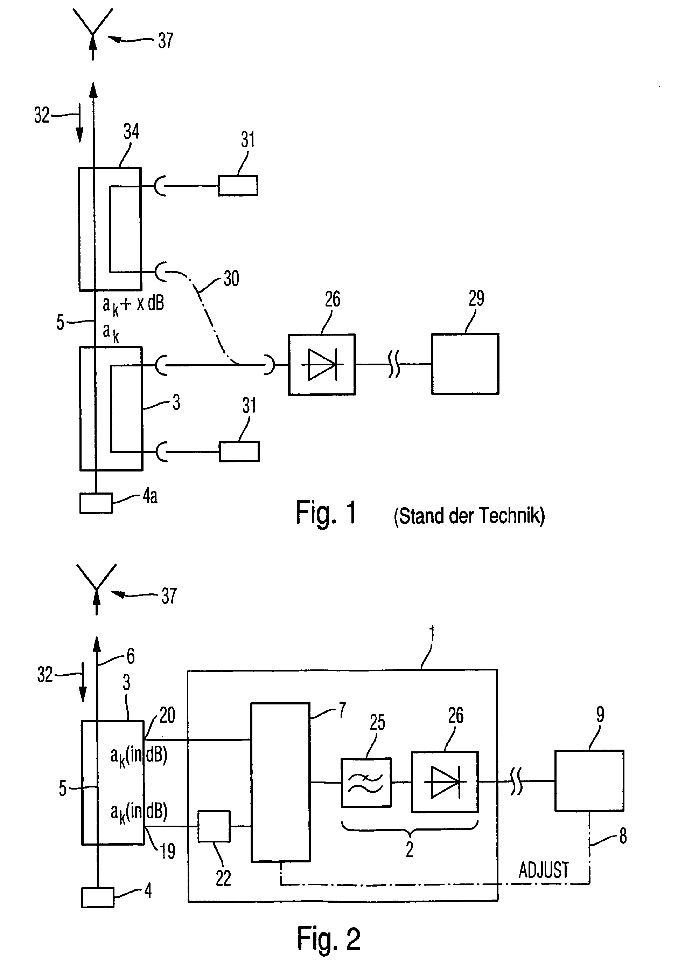

Zum besseren Verständnis der erfindungsgemäßen Maßnahmen wird anhand von Fig. 1 der Stand der Technik erläutert, wobei Bauteile, die sowohl Bestandteile des Messsystems gemäß dem Stand der Technik als auch Bestandteile der erfindungsgemäßen Kalibiervorrichtung bzw. des erfindungsgemäßen Kalibrierverfahrens sind mit gleichen Bezugszeichen gekennzeichnet sind.

Fig. 1 zeigt ein Messsystem gemäß dem Stand der Technik, zum Abgleich der gemessenen Vorlauf- und Rücklaufleistung und zur anschließenden wahlweisen Messung der Vorlauf- oder der Rücklaufleistung in einem Sendesystem 4a. Die Vorlaufleistung 6 entspricht der von dem Sendesystem 4a emittierten Sendeleistung, die das Sendesystem 4a in zur angeschlossenen Antenne 37 überträgt. Die Rücklaufleistung 32 entspricht der Leistung, die von der Antenne 37 auf die Sendeleitung 5 des Sendesystems 4a reflektiert wird, wobei diese reflektierte Leistung zum Sendesystem 4a hin übertragen wird, und die reflektierte Leistung in entgegengesetzter Richtung zur Vorlaufleistung 6 transportiert wird.

Die auf eine Sendeleitung 5 reflektierte Leistung, i.e. die Rücklaufleistung 32, muss messtechnisch mit einer bestimmten Genauigkeit ermittelt werden, da sie einzelne Bauteile des Sendesystems 4a oder das ganze Sendesystem 4a selbst zerstören kann, so dass bei einer Überschreitung eines vorher festgelegten Schwellwertes ein Alarm oder ein Abschaltmechanismus aktiviert wird, der das Sendesystem 4a vor Beschädigung infolge von hoher Rücklaufleistungsaufnahme bewahrt.

Ein im Messsystem gemäß des Standes der Technik vorgesehener Messrichtkoppler 3, dessen Koppeldämpfung aₖ (in dB) beträgt, koppelt einen um einen festgelegten Faktor, der aₖ (in dB) entspricht, verringerten Teil der Vorlaufleistung 6 aus und führt diesen ausgekoppelten Teil der Vorlaufleistung 6 einem Gleichrichter 26 zu, der diese um den festgelegten Faktor verringerte Vorlaufleistung 6 in ein Gleichspannungssignal wandelt. Dieses Gleichspannungssignal ist eine Eingangsgröße für eine Anzeigeeinheit 29. In der Anzeigeeinheit 29 wird die Zuordnung eines am Eingang anliegenden analogen Gleichspannungssignals mittels eines Analog/Digital-Konverters zu einem diskreten, digitalen Messwert vorgenommen. Der dem Gleichspannungssignal zugeordnete digitale Messwert wird von der Anzeigeeinheit 29 angezeigt.

Damit der diskrete, digitale Messwert der Vorlaufleistung 6 von der Anzeigeeinheit 29 mit hoher Genauigkeit angezeigt werden kann, muss das Messsystem kalibriert und abgeglichen werden. Das bedeutet, dass für einen bekannten Eingangswert ein anzuzeigender Messwert festgelegt wird. Die Kalibrierung und der Abgleich des Messsystems hinsichtlich der zu messenden Vorlaufleistung 6 ist relativ einfach. Die Vorlaufleistung 6 entspricht dabei der Ausgangsleistung des Sendesystems 4a, die entweder sehr genau bestimmt werden kann oder durch einen Nennwert gegeben ist, der eine bekannte Toleranz aufweist. Es muss lediglich bei einer bestimmten und mit einer bekannten Genauigkeit gegebenen Leistung die Anzeige auf den Nennwert der Vorlaufleistung 6 eingestellt werden. Dies kann mittels eines nicht weiter dargestellten Potentiometers oder unter Anwendung eines prozessgesteuerten Algorithmus an der Anzeigeeinheit 29 erfolgen.

Eine Kalibrierung und ein Abgleich des Messsystems 4a im Hinblick auf eine genaue Anzeige der Rücklaufleistung 32 ist komplizierter, da die Rücklaufleistung 32 im Betriebsfall betragsmäßig sehr viel geringer ist als die Vorlaufleistung 6 und in der Regel unbekannt ist. Dazu wird ein schon bekannter Referenzwert herangezogen, wobei wie in Fig. 1 angedeutet, beim Stand der Technik ein Umstecken eines Koaxialkabels 30 auf einen Referenzrichtkoppler 34 erforderlich ist und das Messsystem abgeglichen wird. Dadurch wird der Messbereich empfindlicher, d.h. kleinere Messwerte können mit einer höheren Genauigkeit angezeigt werden.

Der erste Schritt, um das Messsystem zu kalibrieren und abzugleichen, so dass die Anzeigeeinheit 29 eine genaue Anzeige der gemessenen Rücklaufleistung 32 liefert, besteht darin, dass aus dem Messrichtkoppler 3 ein um die Koppeldämpfung aₖ (in dB) verringerter Teil der Rücklaufleistung 32 dem Gleichrichter 26, der als Detektor dient, zugeführt wird. Ein zweiter Ausgang des Messrichtkopplers 3 ist dabei mit einem Abschlusswiderstand 31 abgeschlossen, um eine gute Richtschärfe des Messrichtkopplers 3 zu gewährleisten. Da nur die Vorlaufleistung 6 des Sendesystems 4a exakt bekannt ist, wird bei der Kalibrierung und dem Abgleich des Messsystems im Hinblick auf eine genaue Anzeige der Rücklaufleistung 32 an der Anzeigeeinheit 29 der Eingang des Gleichrichters 26 an einen Vorlaufausgang eines zweiten Messrichtkopplers, der in dem Messsystem als Referenzrichtkoppler 34 vorgesehen ist, mittels des Koaxialkabels 30 angeschlossen.

Dabei wird ein bekannter Referenzwert erzeugt, der der mit aₖ+x (in dB) gedämpften Vorlaufleistung 6 entspricht. Der Referenzwert ergibt sich aus der um die Koppeldämpfung aₖ+x (in dB) verringerten Vorlaufleistung 6, wobei bei der Kalibrierung die Koppeldämpfung für die Dämpfung der als Referenzwert vorgesehenen Vorlaufleistung 6 um x (in dB) höher eingestellt ist als bei der eigentlichen Messung der Rücklaufleistung 32. Dies hat zur Folge, dass der Referenzwert stärker gedämpft wird, um den Gleichrichter 26 beim Kalibrierungsvorgang und dem Abgleich des Messsystems für eine korrekte Anzeige des erfassten Messwertes der Rücklaufleistung 32 mit der Vorlaufleistung 6 als Referenzwert nicht zu übersteuern.

Der Ausgang des Messrichtkopplers 3 bei der Messung der Rücklaufleistung 32 ist somit empfindlicher und es wird relativ zum Referenzrichtkoppler 34 eine Leistung angezeigt, die um einen Faktor, der x (in dB) entspricht erhöht ist. Die an der Anzeigeeinheit 29 angezeigte Leistung muss daher mit einem Faktor, der x (in dB) entspricht, nach unten skaliert werden. Der Kalibriervorgang und der Abgleich erfolgt gemäß Fig. 1 beim Stand der Technik manuell durch Umstecken des Koaxialkabels 30 auf den Referenzrichtkoppler 34 und einer anschließenden Justage der Leistungsanzeige z. B. mittels eines nicht weiter dargestellten Potentiometers am Gleichrichter 26 oder mit Hilfe eines prozessorgesteuerten Algorithmus in der Anzeigeeinheit 29.

Der Kalibrier- und Abgleichprozess besteht darin, dass vor der Messung der Rücklaufleistung 32 der Referenzrichtkoppler 34, der eine um einen bekannten Faktor, der x (in dB) entspricht, erhöhte Dämpfung aufweist, über den Gleichrichter 26 an der Anzeigeeinheit 29 angeschlossen wird. Da der Faktor x (in dB) bekannt ist, muss die Anzeige bei der Messung der Rücklaufleistung 32 um diesen Faktor nach unten skaliert werden. Nachdem dieser Schritt ausgeführt wurde, ist das Messsystem dafür präpariert, die Rücklaufleistung 32, die im Betriebsfall typischerweise sehr viel geringer ist als die Vorlaufleistung 6, an der Anzeigeeinheit 29, deren Messbereich für eine genaue Messung kleinerer Leistungen eingestellt ist, anzuzeigen. Dafür muss das Koaxialkabel 30 aber wieder auf den ersten Messrichtkoppler 3 mit der geringeren Dämpfung zurückgesteckt werden.

Fig. 2 zeigt ein vereinfachtes Schaltbild einer Kalibriervorrichtung 1 zum Abgleich und zum Messen einer Vorlaufleistung 6 und einer Rücklaufleistung 32 über einen einzigen Messrichtkoppler 3, der an eine Hochfrequenz-Sendeeinrichtung 4 angeschlossenen ist, wobei eine Steuer- und Anzeigeeinheit 9 die von einer angeschlossenen Antenne 37 eine auf die Sendeleitung 5 der Hochfrequenz-Sendeeinrichtung 4 reflektierte Rücklaufleistung 32 anzeigt. Dabei ist der Referenzwert für den Kalibrierungs- und Abgleichprozess auch hier die bekannte Vorlaufleistung 6 der Hochfrequenz-Sendeeinrichtung 4.

Die Kalibriervorrichtung 1 weist einen Umschalter 7 auf, der über eine Steuerleitung 8 mit der Steuer- und Anzeigeeinheit 9 verbunden ist. Die Steuer- und Anzeigeeinheit 9, die vorzugsweise von dem Messsensor 2 der erfindungsgemäßen Kalibriervorrichtung 1 abgesetzt angeordnet ist, generiert ein den Umschalter 7 betätigendes Steuersignal und gibt dieses auf die Steuerleitung 8. Dabei wird von einer Messung der Rücklaufleistung 32 auf die Messung der Vorlaufleistung 6, umgeschaltet, wobei die Messung der bekannten und gedämpften Vorlaufleistung 6 der Kalibriermessung entspricht und die Messung der Vorlauf- 6 und der Rücklaufleistung 32 über ein und denselben Messrichtkoppler 3 durchgeführt wird. Das den Umschalter 7 betätigende Steuersignal ist ein "ADJUST"-Signal, das im Befehlsvorrat der abgesetzten Steuer- und Anzeigeeinheit 9 gespeichert ist und von dieser bei einem bestimmten Ereignis generiert und auf die zum Umschalter 7 führende Steuerleitung 8 gegeben wird, so dass bei einem aktiven Zustand des "ADJUST"-Signals der Umschalter 7 sich in der Abgleichstellung für die Messung der Vorlaufleistung 6 und der Rücklaufleistung 32 befindet und anschließend die Messung der Vorlaufleistung 6 durchgeführt wird.

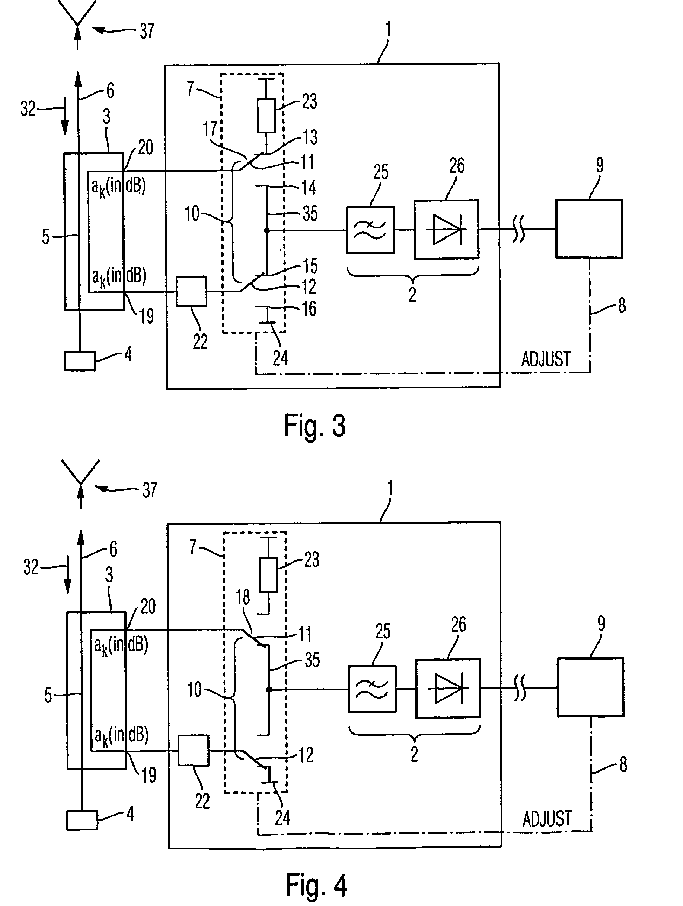

Fig. 3 zeigt ein detaillierteres Schaltbild eines ersten Schaltzustandes 17 einer erfindungsgemäßen Kalibriervorrichtung 1 zum Abgleich der mittels eines einzigen Messrichtkopplers gemessenen Vorlauf- 6 und Rücklaufleistung 32, wobei insbesondere der Umschalter 7 genauer dargestellt ist. Der Umschalter 7, der im Ausführungsbeispiel ein Zweifachschalter 10 mit einem ersten Schalter 11 und einem zweiten Schalter 12 mit jeweils einer ersten Kontaktstelle 13, 15 und einer zweiten Kontaktstelle 14, 16 ist, erzeugt wahlweise einen ersten Schaltzustand 17 oder einen zweiten Schaltzustand 18, wobei oberer Schalter 11 und unterer Schalter 12 gleichzeitig entweder auf die obere mit einem Abschlusswiderstand 23 abgeschlossene Kontaktstelle 13 des ersten Schalters 11 und auf die obere Kontaktstelle 15 des zweiten Schalters 12 oder auf die untere Kontaktstelle 14 des ersten Schalters 11 und auf die untere mit der Masse 24 verbundenen untere Kontaktstelle 16 des zweiten Schalters 12 geschaltet sind.

Der erste Schaltzustand 17 ist dadurch festgelegt, dass der erste Schalter 11 und der zweite Schalter 12 gleichzeitig die ersten Kontaktstellen 13, 15 des Zweifachschalters 10 kontaktieren.

Der in Fig. 4 gezeigte zweite Schaltzustand 18 ist dadurch festgelegt, dass der erste Schalter 11 und der zweite Schalter 12 gleichzeitig die zweiten Kontaktstellen 14, 16 des Zweifachschalters kontaktieren. Liegt der erste Schaltzustand 17 vor, so wird nach dem Abgleich mittels der gedämpft ausgekoppelten Vorlaufleistung 6 an der abgesetzten Steuer- und Anzeigeeinheit 9 der Messwert der Vorlaufleistung 6 angezeigt. Liegt der zweite Schaltzustand 18 vor, so zeigt die abgesetzte Steuer- und Anzeigeeinheit 9 die Rücklaufleistung 32 an, nachdem die abgesetzte Steuer- und Anzeigeeinheit 9 mit Hilfe der bekannten Vorlaufleistung 6 korrigiert wurde und ihr Messbereich so erweitert wurde, dass auch geringe Leistungen, wie die Rücklaufleistung 32 mit einer hinreichenden Genauigkeit angezeigt werden können.

In der erfindungsgemäßen Kalibriervorrichtung 1 ist eine als Messsensor 2 dienende Reihenschaltung eines Tiefpasses 25 und eines Gleichrichters 26 vorgesehen, wobei vor dem Tiefpass 25 der Umschalter 7 angebracht ist, der zur einen Seite eine serielle Verbindung zu dem Messrichtkoppler 3 aufweist und zur anderen Seite mit dem aus dem Tiefpass 25 und dem Gleichrichter 26 bestehenden Messsensor 2 verbunden ist. Der Tiefpass 25 weist einen Frequenzgang auf, der im Nutzfrequenzbereich etwa komplementär zu dem Frequenzgang des Messrichtkopplers 3 ist. Der Messrichtkoppler 3 weist einen ersten Koppelausgang 19 zum Auskoppeln der Vorlaufleistung 6 und einen zweiten Koppelausgang 20 zum Auskoppeln der Rücklaufleistung 32 auf, wobei die aus dem ersten und dem zweiten Koppelausgang 19, 20 ausgekoppelte Vorlaufleistung 6 bzw. Rücklaufleistung 32 jeweils der gleichen festgelegten Koppeldämpfung von aₖ (in dB) unterliegt.

Der erste Koppelausgang 19 des Messrichtkopplers 3 ist über ein einen festgelegten Dämpfungsfaktor x (in dB) aufweisendes Dämpfungsglied 22 mit dem zweiten Schalter 12 des Zweifachschalters 10 verbunden und der zweite Koppelausgang 20 des Messrichtkopplers 3 ist direkt an den ersten Schalter 11 des Zweifachschalters 10 angeschlossen, wobei das Dämpfungsglied 22, das den ersten Koppelausgang 19 mit dem zweiten Schalter 12 verbindet, vorzugsweise einen angepassten Eingangswiderstand von z. B. 50 Ohm aufweist.

Die Verschaltung im Umschalter 7 der erfindungsgemäßen Kalibriervorrichtung 1 erfolgt so, dass die zweite Kontaktstelle 14 des ersten Schalters 11 mit der ersten Kontaktstelle 15 des zweiten Schalters 12 über eine Verbindungsleitung 35 verbunden ist, die mit dem Tiefpass 25 des Messsensors 2 verbunden ist. Dabei ist in dem ersten Schaltzustand 17 eine Verbindung der Verbindungsleitung 35 mit dem ersten Koppelausgang 19 des Messrichtkopplers 3 über das Dämpfungsglied 22 und in dem zweiten Schaltzustand 18 eine Verbindung der Verbindungsleitung 35 mit dem zweiten Koppelausgang 20 des Messrichtkopplers 3 vorgesehen, wobei das von der Steuer- und Anzeigeeinheit 9 generierte und über die Steuerleitung 8 zum Umschalter 7 übertragene "ADJUST"-Signal beim Vorliegen eines aktiven Zustandes vom zweiten Schaltzustand 18 in den ersten Schaltzustand 17 schaltet und somit bewirkt, dass beim Vorliegen des ersten Schaltzustandes 17 die Vorlaufleistung 6 an der Steuer- und Anzeigeeinheit 9 angezeigt wird.

Fig. 4 zeigt ein detaillierteres Schaltbild eines zweiten Schaltzustands 18 einer erfindungsgemäßen Kalibriervorrichtung 1 zum Abgleich der an einer Hochfrequenz-Sendeeinrichtung 4 mittels eines einzigen Messrichtkopplers 3 gemessenen Vorlauf- 6 und Rücklaufleistung 32. Der Umschalter 7, der als ein Zweifachschalter 10 mit einem ersten Schalter 11 und einem zweiten Schalter 12 und mit jeweils einer ersten Kontaktstelle 13, 15 und einer zweiten Kontaktstelle 14, 16 ausgeführt ist, erzeugt wahlweise einen ersten Schaltzustand 17 oder einen zweiten Schaltzustand 18, wobei der erste Schalter 11 und der zweite Schalter 12 gleichzeitig entweder auf die erste mit einem Abschlusswiderstand 23 abgeschlossene Kontaktstelle 13 des ersten Schalters 11 und auf die zweite Kontaktstelle 15 des zweiten Schalters 12 oder auf die zweite Kontaktstelle 14 des ersten Schalters 11 und auf die zweite mit der Masse 24 verbundenen Kontaktstelle 16 des zweiten Schalters 12 geschaltet sind.

Der zweite Schaltzustand 18 ist, wie in Fig. 4 gezeigt, dadurch festgelegt, dass der erste Schalter 11 und der zweite Schalter 12 gleichzeitig die zweiten Kontaktstellen 14, 16 kontaktieren. Liegt, wie in Fig. 4 gezeigt, der zweite Schaltzustand 18 vor, so kann die abgesetzte Steuer- und Anzeigeeinheit 9 die auf der Sendeleitung 5 transportierte Rücklaufleistung 32 messen und anzeigen.

Die Verschaltung im Umschalter 7 der erfindungsgemäßen Kalibriervorrichtung 1 erfolgt so, dass die zweite Kontaktstelle 14 des ersten Schalters 11 mit der ersten Kontaktstelle 15 des zweiten Schalters 12 über eine Verbindungsleitung 35 verbunden ist, die mit dem Tiefpass 25 des Messsensors 2 verbunden ist. Dabei ist mit dem zweiten Schaltzustand 18, wie aus Fig. 4 ersichtlich ist, eine Verbindung der Verbindungsleitung 35 mit dem zweiten Koppelausgang 20 des Messrichtkopplers 3 vorgesehen, wobei das von der Steuer- und Anzeigeeinheit 9 generierte und über die Steuerleitung 8 zum Umschalter 7 übertragene "ADJUST"-Signal im aktiven Zustand den ersten Schaltzustand 17 festlegt, der über eine Verbindung des Messsensors 2 mit dem ersten Koppelausgang 19 des Messrichtkopplers 3 definiert ist.

Das erfindungsgemäße Kalibrierverfahren zum Abgleich der an einer Hochfrequenz-Sendeeinrichtung 4 gemessenen Vorlauf- 6 und Rücklaufleistung 32 mittels einer Kalibriervorrichtung 1, die nur einen einzigen Messrichtkoppler 3 und nur einen Messsensor 2 aufweist und an eine Steuer- und Anzeigeeinheit 9 angeschlossenen ist, umfasst mehrere Schritte.

Im ersten Schritt betätigt das über die Steuerleitung 8 transportierte Steuersignal einen in der erfindungsgemäßen Kalibriervorrichtung 1 vorgesehenen Umschalter 7, wobei von einer Messung der Rücklaufleistung 32 auf eine Messung der Vorlaufleistung 6 geschaltet wird. Die Messung der Vorlaufleistung 6 erfolgt über denselben, in der erfindungsgemäßen Kalibriervorrichtung 1 vorgesehenen Messrichtkoppler 3 und denselben Messsensor 2 und wird von der Steuer- und Anzeigeeinheit 9 angezeigt, nachdem diese den mit einem Referenzwert abgelichenen Messwert der Vorlaufleistung 6 angezeigt hat. Dabei kann die Steuer- und Anzeigeeinheit 9 von der erfindungsgemäßen Kalibriervorrichtung 1 abgesetzt angeordnet werden.

Der aktive Zustand des Steuerbefehls "ADJUST" wird in der erfindungsgemäßen Kalibriervorrichtung 1 dahingehend interpretiert, dass er den Umschalter 7 umlegt und so von einer Messung der Rücklaufleistung 32 auf eine Messung der Vorlaufleistung 6 umschaltet. Der Umschalter 7 ist als Zweifachschalter 10 mit einem ersten Schalter 11 und einem zweiten Schalter 12 ausgeführt, wobei der erste Schalter 11 und der zweite Schalter 12 gleichzeitig entweder auf eine erste Kontaktstelle 13, 15 oder auf eine zweite Kontaktstelle 14, 16 geschaltet wird. Mittels des Zweifachschalters 10 wird wahlweise der erste Schaltzustand 17 oder der zweite Schaltzustand 18 erzeugt, wobei beim Vorliegen des ersten Schaltzustandes 17 die Kalibriervorrichtung 1 den Messrichtkoppler 3 mit der auf der Sendeleitung 5 transportierten Vorlaufleistung 6 als Referenzwert abgleicht.

Im ersten Schaltzustand 17 wird der Messrichtkoppler 3 mittels der erfindungsgemäßen Kalibriervorrichtung 1 mit der ausgekoppelten und gedämpften Vorlaufleistung 6 abgeglichen. Der erste Schaltzustand 17 tritt ein, nachdem der dafür vorgesehene Steuerbefehl "ADJUST" von der Steuer- und Anzeigeeinheit 9 generiert, in den aktiven Zustand versetzt, zur erfindungsgemäßen Kalibriervorrichtung 1 übertragen und dort interpretiert wurde. Das erfindungsgemäße Verfahren sieht eine Verschaltung eines mit zwei Koppelausgängen 19, 20 versehenen Messrichtkopplers 3, eines Umschalters 7 und eines Messsensors 2 in der gegebenen Reihenfolge vor, wobei der Messsensor 2 aus einem Tiefpass 25 und einem Gleichrichter 26 besteht. Dabei wird der Messrichtkoppler 3 so dimensioniert, dass wahlweise die Vorlaufleistung 6 oder die Rücklaufleistung 32 mit einer festgelegten, vom Frequenzgang unabhängigen Koppeldämpfung von aₖ (in dB) ausgekoppelt wird. Der Tiefpass 25 dient dabei der Kompensation des Frequenzgangs des Messrichtkopplers 3, der ein Hochpass-Verhalten zeigt. Dabei wird der erste Koppelausgang 19 des Messrichtkopplers 3 über ein Dämpfungsglied 22 mit einer definierten Dämpfung x (in dB) mit dem zweiten Schalter 12 des Zweifachschalters 10 und der zweite Koppelausgang 20 des Messrichtkopplers 3 direkt mit dem ersten Schalter 11 des Zweifachschalters 10 verbunden.

Die Erfindung ist nicht auf das dargestellte und beschriebene Ausführungsbeispiel beschränkt. Durch den vorgesehenen Umschalter 7 ist die beim Stand der Technik erforderliche Bestückung mit zwei Detektoren einmal für die Messung der Vorlaufleistung 6 und einmal für die Messung der Rücklaufleistung 32 nicht mehr erforderlich. Es kann ein einziger Messsensor 2 bestehend aus einem einzigen Tiefpass 25 und einem einzigen Gleichrichter 26 bzw. Diodendetektor verwendet werden. Dadurch wird nicht nur der Aufwand der Kalibriervorrichtung 1 verringert, sondern auch die Messgenauigkeit erhöht, denn die Messung der Vorlaufleistung 6 und der Rücklaufleistung 32 erfolgt über den selben Messsensor 2, den selben Tiefpass 25 und dem selben Analog/Digital-Konverter, so dass dort eventuell vorhandene Mess- oder Abgleich-Ungenauigkeiten sich auf die Messung der Vorlaufleistung 6 und die Messung der Rücklaufleistung 32 gleichermaßen auswirken und sich somit gegenseitig kompensieren. Dabei wird sowohl für die Messung der Vorlaufleistung 6 als auch für die Messung der Rücklaufleistung 32 nur ein einziger Abgleich bezüglich der Vorlaufleistung 6 benötigt. Die Anzeige bei der Messung der Rücklaufleistung 32 wird lediglich um den Betrag des Dämpfungsgliedes 22 heruntergerechnet.

## Patentansprüche

1. Kalibriervorrichtung (1) mit einem Messsensor (2) und einer angeschlossenen Steuer- und Anzeigeeinheit (9) zum Abgleich der an einer Hochfrequenz-Sendeeinrichtung (4) über einen einzigen Messrichtkoppler (3) gemessenen Vorlauf- (6) und Rücklaufleistung (32),
wobei der Abgleich bezüglich der bekannten auf einer Sendeleitung (5) von der Hochfrequenz-Sendeeinrichtung (4) zu einer Antenne (37) übertragenen Vorlaufleistung (6) erfolgt,
wobei die Kalibriervorrichtung (1) einen Umschalter (7) aufweist, der über eine Steuerleitung (8) mit der Steuer- und Anzeigeeinheit (9) verbunden ist,
wobei ein von der Steuer- und Anzeigeeinheit (9) den Umschalter (7) betätigendes Steuersignal ausgesandt wird, wodurch von einer Messung der Rücklaufleistung (32) auf eine Messung der Vorlaufleistung (6) mittels des gleichen Messsensors (2) umgeschaltet wird, und
wobei die Messung der Vorlaufleistung (6) und die Messung der Rücklaufleistung (32) über den selben Messrichtkoppler (3) erfolgen,
**dadurch gekennzeichnet,**
**dass** ein erster Koppelausgang (19) des Messrichtkopplers (3), an dem die Vorlaufleistung (6) ausgekoppelt ist, über ein einen festgelegten Dämpfungsfaktor aufweisendes Dämpfungsglied (22) mit einem zweiten Schalter (12) des Umschalters (7) verbunden ist und ein zweiter Koppelausgang (20) des Messrichtkopplers (3), an dem die Rücklaufleistung (32) ausgekoppelt ist, direkt an einen ersten Schalter (11) des Umschalters (7) angeschlossen ist, wobei die Vorlaufleistung (6) und die Rücklaufleistung (32) jeweils der gleichen festgelegten Koppeldämpfung unterliegen,
**dass** der Umschalter (7) ein Zweifachschalter (10) ist, der den ersten Schalter (11) und den zweiten Schalter (12) mit jeweils einer ersten Kontaktstelle (13, 15) und einer zweiten Kontaktstelle (14, 16) aufweist, wobei der erste Schalter (11) und der zweite Schalter (12) gleichzeitig wahlweise in einem ersten Schaltzustand (17) entweder auf die jeweilige erste Kontaktstelle (13, 15) oder in einem zweiten Schaltzustand (18) auf die jeweilige zweite Kontaktstelle (14, 16) des entsprechenden Schalters (11, 12) geschaltet sind,
**dass** die erste Kontaktstelle (13) des ersten Schalters (11) mit einem Abschlusswiderstand (23) abgeschlossen ist und
**dass** die zweite Kontaktstelle (16) des zweiten Schalters (12) direkt mit Masse (24) verbunden ist, wobei das Dämpfungsglied (22) einen angepassten Eingangswiderstand aufweist.

2. Kalibriervorrichtung nach Anspruch 1,
**dadurch gekennzeichnet,**
**dass** die Steuer- und Anzeigeeinheit (9) von dem Messsensor (2) getrennt und abgesetzt angeordnet ist.

3. Kalibriervorrichtung nach Anspruch 1 oder 2,
**dadurch gekennzeichnet,**
**dass** das den Umschalter (7) betätigende Steuersignal in der Steuer- und Anzeigeeinheit (9) generiert wird.

4. Kalibriervorrichtung nach Anspruch 1,
**dadurch gekennzeichnet**
**dass** im ersten Schaltzustand (17) nach dem Abgleich mittels der auf der Sendeleitung (5) der Hochfrequenz-Sendeeinrichtung (4) transportierten Vorlaufleistung (6) als Referenzwert die Messung der Vorlaufleistung (6) erfolgt.

5. Kalibriervorrichtung nach Anspruch 1 oder 4,
**dadurch gekennzeichnet**
**dass** im zweiten Schaltzustand (18) nach dem Abgleich mittels der auf der Sendeleitung (5) der Hochfrequenz-Sendeeinrichtung (4) transportierten Vorlaufleistung als Referenzwert die Messung der auf der Sendeleitung (5) der Hochfrequenz-Sendeeinrichtung (4) transportierten und von der Antenne reflektierten Rücklaufleistung (32) erfolgt.

6. Kalibriervorrichtung nach Anspruch 1,
**dadurch gekennzeichnet**
**dass** ein Tiefpass (25) und ein Gleichrichter (26) als Messsensor (2) vorgesehen sind und der vor dem Tiefpass (25) angeordnete Umschalter (7) den Messsensor (2) wahlweise mit einem der beiden Koppelausgänge (19, 20) des Messrichtkopplers (3) verbindet, wobei der Tiefpass (25) einen Frequenzgang hat, der im Nutzfrequenzbereich dergestalt komplementär zu dem Frequenzgang des Messrichtkopplers (3) ist, dass der Tiefpass den Frequenzgang des Messrichtkopplers (3) kompensiert.

7. Kalibriervorrichtung nach Anspruch 6,
**dadurch gekennzeichnet,**
**dass** die zweite Kontaktstelle (14) des ersten Schalters (11) mit der ersten Kontaktstelle (15) des zweiten Schalters (12) über eine Verbindungsleitung (35) verbunden ist.

8. Kalibriervorrichtung nach Anspruch 7,
**dadurch gekennzeichnet**
**dass** die Verbindungsleitung (35) mit dem Tiefpass (25) des Messsensors (2) verbunden ist.

9. Kalibriervorrichtung nach einem der Ansprüche 1, 4 oder 5,
**dadurch gekennzeichnet**
**dass** der erste Schaltzustand (17) eine Verbindung des Messsensors (2) mit dem ersten Koppelausgang (19) des Messrichtkopplers (3) festlegt.

10. Kalibriervorrichtung nach einem der Ansprüche 1, 4, 5 oder 9,
**dadurch gekennzeichnet**
**dass** der zweite Schaltzustand (18) eine Verbindung des Messsensors (2) mit dem zweiten Koppelausgang (20) des Messrichtkopplers (3) festlegt.

11. Kalibrierverfahren mit einer Kalibriervorrichtung zum Abgleich der in einer an eine Hochfrequenz-Sendeeinrichtung (4) angeschlossenen Steuer- und Anzeigeeinheit (9) gemessenen Vorlauf- (6) und Rücklaufleistung (32),
wobei der Abgleich bezüglich der auf einer Sendeleitung (5) der Hochfrequenz-Sendeeinrichtung (4) zu einer Antenne (37) übertragenen Vorlaufleistung (6) erfolgt, und der Referenzwert für den Abgleich die bekannte Vorlaufleistung (6) der Hochfrequenz-Sendeeinrichtung (4) ist, und
wobei eine Steuerleitung (8) die Kalibriervorrichtung (1) mit der Steuer- und Anzeigeeinheit (9) verbindet,
mit folgenden Verfahrensschritten:
- die Steuer- und Anzeigeeinheit (9) generiert ein Steuersignal,
- das über die Steuerleitung (8) übertragene Steuersignal betätigt einen in der Kalibriervorrichtung (1) vorgesehenen Umschalter (7), woraufhin von einer Messung der Vorlaufleistung (6) auf eine Messung der Rücklaufleistung (32) umgeschaltet wird, wobei die Messung der Rücklaufleistung (32) und die Messung der Vorlaufleistung (6) über den selben, in der Kalibriervorrichtung (1) vorgesehenen Messrichtkoppler (3) und denselben Messsensor (2) erfolgt,
**dadurch gekennzeichnet,**
**dass** ein erster Koppelausgang (19) des Messrichtkopplers (3), an dem die Vorlaufleistung (6) ausgekoppelt wird, über ein einen festen Dämpfungsfaktor aufweisendes Dämpfungsglied (22) mit einem zweiten Schalter (12) des Umschalters (7) verbunden wird und ein zweiter Koppelausgang (20) des Messrichtkopplers (3), an dem die Rücklaufleistung (32) ausgekoppelt wird, direkt an einen ersten Schalter (11) des Umschalters (7) angeschlossen wird, wobei die Vorlaufleistung (6) und die Rücklaufleistung (32) jeweils der gleichen festgelegten Koppeldämpfung unterliegen,
**dass** der Umschalter (7) ein Zweifachschalter (10) ist, der den ersten Schalter (11) und den zweiten Schalter (12) mit jeweils einer ersten Kontaktstelle (13, 15) und einer zweiten Kontaktstelle (14, 16) aufweist, wobei der erste Schalter (11) und der zweite Schalter (12) gleichzeitig wahlweise in einem ersten Schaltzustand (17) entweder auf die jeweilige erste Kontaktstelle (13, 15) oder in einem zweiten Schaltzustand (18) auf die jeweilige zweite Kontaktstelle (14, 16) des entsprechenden Schalters (11, 12) geschaltet werden,
**dass** die erste Kontaktstelle (13) des ersten Schalters (11) mit einem Abschlusswiderstand (23) abgeschlossen wird und
**dass** die zweite Kontaktstelle (16) des zweiten Schalters (12) direkt mit Masse (24) verbunden wird, wobei das Dämpfungsglied (22) einen angepassten Eingangswiderstand aufweist.

## Claims

1. Calibration device (1) comprising:
a measuring sensor (2) and a connected control and display unit (9) for adjusting the forward power (6) and reflected power (32) measured in a high-frequency transmission device (4) via a single measuring directional coupler (3),
the adjustment being made with reference to the known forward power (6) transmitted on a transmission line (5) from the high-frequency transmission device (4) to an antenna (37).
the calibration device (1) having a changeover switch (7) which is connected via a control line (8) to the control and display unit (9), a control signal which activates the changeover switch (7) being transmitted by the control and display unit (9), thereby switching from a measurement of the reflected power (32) to a measurement of the forward power (6) by means of the same measuring sensor (2), and
the forward power (6) and the reflected power (32) being measured via the same measuring directional coupler (3),
**characterised in that**
a first coupling output (19) of the measuring directional coupler (3), at which the forward power (6) is decoupled, is connected to a second switch (12) of the changeover switch (7) via an attenuator (22) having a fixed attenuation factor, and
a second coupling output (20) of the measuring directional coupler (3), at which the reflected power (32) is decoupled, is connected directly to a first switch (11) of the changeover switch (7), the forward power (6) and the reflected power (32) each being subject to the same fixed coupling attenuation, **in that** the changeover switch (7) is a double-action switch (10), which provides both the first switch (11) and the second switch (12) with a first contact position (13, 15) and a second contact position (14, 16), the first switch (11) and the second switch (12) being connected simultaneously optionally in a first switching state (17) either to the respective first contact position (13, 15) or in a second switching state (18) to the respective second contact position (14, 16) of the corresponding switch (11, 12), **in that** the first contact position (13) of the first switch (11) is terminated with a terminating resistance (23), and **in that** the second contact position (16) of the second switch (12) is connected directly to earth (24), the attenuator (22) having an adapted input resistance.

2. Calibration device according to claim 1,
**characterised in that**
the control and display unit (9) is arranged separately and at a distance from the measuring sensor (2).

3. Calibration device according to either claim 1 or claim 2,
**characterised in that**
the control signal activating the changeover switch (7) is generated in the control and display unit (9).

4. Calibration device according to claim 1,
**characterised in that**,
in the first switching state (17), the forward power (6) is measured according to the adjustment taking as a reference value the forward power (6) which is transported on the transmission line (5) of the high-frequency transmission device (4).

5. Calibration device according to either claim 1 or claim 4,
**characterised in that**,
in the second switching state (18), the reflected power (32), which is transported on the transmission line (5) of the high-frequency transmission device (4) and reflected by the antenna, is measured according to the adjustment taking as a reference value the forward power which is transported on the transmission line (5) of the high-frequency transmission device (4).

6. Calibration device according to claim 1,
**characterised in that**
a low-pass filter (25) and a rectifier (26) are provided as a measuring sensor (2) and the changeover switch (7) arranged upstream of the low-pass filter (25) connects the measuring sensor (2) optionally to one of the two coupling outputs (19, 20) of the measuring directional coupler (3), the low-pass filter (25) having a frequency response, which is complementary, in the useful frequency range, to the frequency response of the measuring directional coupler (3) is such a way that the low-pass filter compensates the frequency response of the measuring directional coupler (3).

7. Calibration device according to claim 6,
**characterised in that**
the second contact position (14) of the first switch (11) is connected to the first contact position (15) of the second switch (12) via a connecting line (35).

8. Calibration device according to claim 7,
**characterised in that**
the connecting line (35) is connected to the low-pass filter (25) of the measuring sensor (2).

9. Calibration device according to any of claims 1, 4 or 5,
**characterised in that**
the first switching state (17) establishes a connection of the measuring sensor (2) to the first coupling output (19) of the measuring directional coupler (3).

10. Calibration device according to any of claims 1, 4, 5 or 9,
**characterised in that**
the second switching state (18) establishes a connection of the measuring sensor (2) to the second coupling output (20) of the measuring directional coupler (3).

11. Calibration method comprising a calibration device for the adjustment of the forward power (6) and reflected power (32) measured in a control and display unit (9) connected to a high-frequency transmission device (4), the adjustment being made with regard to the forward power (6) transmitted on a transmission line (5) of the high-frequency transmission device (4) to an antenna (37), and the reference value for the adjustment being the known forward power (6) of the high-frequency transmission device (4), and a control line (8) connecting the calibration device (1) to the control and display unit (9),comprising the following method steps:
- the control and display unit (9) generating a control signal, and
- the control signal transmitted via the control line (8) activating a changeover switch (7) provided in the calibration device (1), thereby switching from a measurement of the forward power (6) to a measurement of the reflected power (32), the measurement of the reflected power (6) and of the forward power (6) being measured via the same measuring directional coupler (3) provided in the calibration device (1) and via the same measuring sensor (2),
**characterised in that**
a first coupling output (19) of the measuring directional coupler (3), at which the forward power (6) is decoupled, is connected to a second switch (12) of the changeover switch (7) via an attenuator (22) having a fixed attenuation factor, and
a second coupling output (20) of the measuring directional coupler (3), at which the reflected power (32) is decoupled, is connected directly to a first switch (11) of the changeover switch (7), the forward power (6) and the reflected power (32) each being subjected to the same fixed coupling attenuation, **in that** the changeover switch (7) is a double-action switch (10), which provides both the first switch (11) and the second switch (12) with a first contact position (13, 15) and a second contact position (14, 16), the first switch (11) and the second switch (12) being connected simultaneously optionally in a first switching state (17) either to the respective first contact position (13, 15) or in a second switching state (18) to the respective second contact position (14, 16) of the corresponding switch (11, 12), **in that** the first contact position (13) of the first switch (11) is terminated with a terminating resistance (23), and **in that** the second contact position (16) of the second switch (12) is connected directly to earth (24), the attenuator (22) having an adapted input resistance.

## Revendications

1. Dispositif de calibrage (1) comportant un capteur de mesure (2) et une unité de commande et d'affichage associée (9) pour régler la puissance directe (6) et la puissance réfléchie (32) mesurées dans un dispositif de transmission à haute fréquence (4) par l'intermédiaire d'un coupleur directionnel de mesure unique (3),
dans lequel le réglage s'effectue par rapport à la puissance directe (6) connue transmise sur une ligne de transmission (5) du dispositif de transmission à haute fréquence (4) à une antenne (37),
dans lequel le dispositif de calibrage (1) présente un commutateur (7), qui est relié à l'unité de commande et d'affichage (9) par l'intermédiaire d'une ligne de commande (8),
dans lequel un signal de commande actionnant le commutateur (7) est envoyé depuis l'unité de commande d'affichage (9), grâce auquel on peut passer d'une mesure de la puissance réfléchie (32) à une mesure de la puissance directe (6) grâce au même capteur de mesure (2), et
dans lequel la mesure de la puissance directe (6) et la mesure de la puissance réfléchie (32) sont effectuées par l'intermédiaire du même coupleur directionnel de mesure (3),
**caractérisé en ce que**
une première sortie de couplage (19) du coupleur directionnel de mesure (3), auquel la puissance directe (6) est couplée, est reliée par l'intermédiaire d'un élément d'affaiblissement (22) présentant un facteur d'affaiblissement déterminé à un second interrupteur (12) du commutateur (7) et une seconde sortie de couplage (20) du coupleur directionnel de mesure (3), auquel la puissance réfléchie (32) est couplée, est reliée directement à un premier interrupteur (11) du commutateur (7), dans lequel la puissance directe (6) et la puissance réfléchie (32) sont soumises respectivement au même affaiblissement de couplage déterminé,
en que le commutateur (7) est un interrupteur double (10), qui présente le premier interrupteur (11) et le second interrupteur (12) avec respectivement un premier point de contact (13, 15) et un second point de contact (14, 16), dans lequel le premier interrupteur (11) et le second interrupteur (12) sont reliés simultanément au choix dans un premier état de commutation (17) soit sur le premier point de contact respectif (13, 15) soit dans un second état de commutation (18) sur le second point de contact respectif (14, 16) de l'interrupteur correspondant (11, 12),
**en ce que** le premier point de contact (13) du premier interrupteur (11) est fermé par une résistance terminale (23) et
**en ce que** le second point de contact (16) du second interrupteur (12) est relié directement à la masse (24), dans lequel l'élément d'affaiblissement (22) présente une résistance d'entrée adaptée.

2. Dispositif de calibrage selon la revendication 1, **caractérisé en ce que**
l'unité de commande et d'affichage (9) est disposée séparée et distincte du capteur de mesure (2).

3. Dispositif de calibrage selon la revendication 1 ou 2, **caractérisé en ce que**
le signal de commande actionnant le commutateur (7) est généré dans l'unité de commande et d'affichage (9).

4. Dispositif de calibrage selon la revendication 1, **caractérisé en ce que**
la mesure de la puissance directe (6) s'effectue dans le premier état de commutation (17) après le réglage au moyen de la puissance directe (6) transportée sur la ligne de transmission (5) du dispositif de transmission à haute fréquence (4) en tant que valeur de référence.

5. Dispositif de calibrage selon la revendication 1 ou 4, **caractérisé en ce que**
la mesure de la puissance réfléchie (32) transportée sur la ligne de transmission (5) du dispositif de transmission à haute fréquence (4) et réfléchie par l'antenne est effectuée après le réglage au moyen de la puissance directe transportée sur la ligne de transmission (5) du dispositif de transmission à haute fréquence (4) en tant que valeur de référence.

6. Dispositif de calibrage selon la revendication 1, **caractérisé en ce que**
un passe-bas (25) et un redresseur (26) sont prévus en tant que capteur de mesure (2) et le commutateur (7) disposé avant le passe-bas (25) est relié au capteur de mesure (2) au choix à l'une des deux sorties de couplage (19, 20) du coupleur directionnel de mesure (3), dans lequel le passe-bas (25) possède une courbe de fréquence, qui est complémentaire de la courbe de fréquence du coupleur directionnel de mesure (3) dans le domaine de fréquence utile de sorte que le passe-bas compense la courbe de fréquence du coupleur directionnel de mesure (3).

7. Dispositif de calibrage selon la revendication 6, **caractérisé en ce que**
le second point de contact (14) du premier interrupteur (11) est relié au premier point de contact (15) du second interrupteur (12) par l'intermédiaire d'une ligne de raccordement (35).

8. Dispositif de calibrage selon la revendication 7, **caractérisé en ce que**
la ligne de raccordement (35) est reliée au passe-bas (25) du capteur de mesure (2).

9. Dispositif de calibrage selon l'une des revendications 1, 4 ou 5, **caractérisé en ce que**
le premier état de commutation (17) détermine une liaison du capteur de mesure (2) avec la première sortie de couplage (19) du coupleur directionnel de mesure (3).

10. Dispositif de calibrage selon l'une des revendications 1, 4, 5 ou 9, **caractérisé en ce que**
le second état de commutation (18) détermine une liaison du capteur de mesure (2) avec la seconde sortie de couplage (20) du coupleur directionnel de mesure (3).

11. Procédé de calibrage comportant un dispositif de calibrage pour régler la puissance directe (6) et la puissance réfléchie (32) mesurées dans une unité de commande et d'affichage (9) reliée à un dispositif de transmission à haute fréquence (4),
dans lequel le réglage est effectué par rapport à la puissance directe (6) transmise sur une ligne de transmission (5) du dispositif de transmission à haute fréquence (4) à une antenne (37), et la valeur de référence pour le réglage est la puissance directe connue (6) du dispositif de transmission à haute fréquence (4), et
dans lequel une ligne de commande (8) relie le dispositif de calibrage (1) à l'unité de commande et d'affichage (9),
comportant les étapes de procédé suivantes :
- l'unité de commande et d'affichage (9) génère un signal de commande,
- le signal de commande transmis par l'intermédiaire de la ligne de commande (8) actionne un commutateur (7) prévu dans le dispositif de calibrage (1), grâce auquel on peut commuter d'une mesure de la puissance directe (6) à une mesure de la puissance réfléchie (32), dans lequel la mesure de la puissance réfléchie (32) et la mesure de la puissance directe (6) sont effectuées par l'intermédiaire du même coupleur directionnel de mesure (3) prévu dans le dispositif de calibrage (1) et le même capteur de mesure (2),
**caractérisé en ce que**
une première sortie de couplage (19) du coupleur directionnel de mesure (3), auquel la puissance directe (6) est couplée, est reliée à un second interrupteur (12) du commutateur (7) par l'intermédiaire d'un élément d'affaiblissement (22) présentant un facteur d'affaiblissement fixe et une seconde sortie de couplage (20) du coupleur directionnel de mesure (3), auquel la puissance réfléchie (32) est couplée, est reliée directement à un premier interrupteur (11) du commutateur (7), dans lequel la puissance directe (6) et la puissance réfléchie (32) sont soumises respectivement au même affaiblissement de couplage déterminé,
**en ce que** le commutateur (7) est un interrupteur double (10), qui présente le premier interrupteur (11) et le second interrupteur (12) avec respectivement un premier point de contact (13, 15) et un second point de contact (14, 16), dans lequel le premier interrupteur (11) et le second interrupteur (12) sont reliés simultanément au choix dans un premier état de commutation (17) soit au premier point de contact respectif (13, 15) soit dans un second état de commutation (18) sur le second point de contact respectif (14, 16) de l'interrupteur correspondant (11, 12),
**en ce que** le premier point de contact (13) du premier interrupteur (11) est fermé par une résistance terminale (23) et
**en ce que** le second point de contact (16) du second interrupteur (12) est relié directement à la masse (24), dans lequel l'élément d'affaiblissement (22) présente une résistance d'entrée adaptée.
